# NEUE EUROPÄISCHE PATENTSCHRIFT

(11) **EP 1 855 261 B2**
(45) Veröffentlichungstag und Bekanntmachung des Hinweises auf die Entscheidung über den Einspruch: **11.06.2014**
(45) Hinweis auf die Patenterteilung: 20.07.2011
(21) Anmeldenummer: 06113828.5
(22) Anmeldetag: 11.05.2006
(51) Int. Cl.: G08B 29/12

(54) **Verfahren und Einrichtung zur Überwachung einer Meldelinie einer Brandmeldeanlage auf Störungen**
Method and device for monitoring a signalling line of a fire alarm system for faults
Procédé et dispositif destinés à la surveillance de perturbations sur une ligne d'avertissement d'une installation d'avertissement d'incendie

(43) Veröffentlichungstag der Anmeldung: 14.11.2007
(73) Patentinhaber: Siemens Aktiengesellschaft, 80333 München (DE)
(72) Erfinder: Schermann, Harald, 82282 Unterschweinbach (DE)
(74) Vertreter: Maier, Daniel Oliver

(56) Entgegenhaltungen:
- DE-C1- 10 048 599
- US-A- 3 665 461
- US-A- 4 385 287
- PATENT ABSTRACTS OF JAPAN Bd. 016, Nr. 460 (P-1427), 24. September 1992 (1992-09-24) & JP 04 163694 A (MATSUSHITA ELECTRIC WORKS LTD), 9. Juni 1992 (1992-06-09)
- PATENT ABSTRACTS OF JAPAN Bd. 2000, Nr. 15, 6. April 2001 (2001-04-06) & JP 2000 339572 A (MATSUSHITA ELECTRIC WORKS LTD), 8. Dezember 2000 (2000-12-08)

## Beschreibung

Die vorliegende Erfindung betrifft ein Verfahren zur Überwachung einer auf Grenzwertmeldetechnik basierenden Meldelinie einer Brandmeldeanlage auf Störungen, wobei die Meldelinie im Betrieb mit einem Linienstrom beaufschlagt ist und ein durch eine TVS-Diode gebildetes Endglied aufweist, und eine Überwachung des Linienstroms und/oder der Linienspannung sowie für die Erkennung von Störungen eine kurzzeitige Erhöhung des Linienstroms erfolgt.

Die Grenzwertmeldetechnik (GMT-Technik), die auch als Gleichstrommeldetechnik oder Kollektivtechnik bezeichnet wird, man spricht im letzteren Fall von so genannten kollektiven Meldelinien und von kollektiven Brandmeldern, ist bei Brandmeldeanlagen seit langem bekannt und ist gegenüber Brandmeldeanlagen mit einzeln adressierbaren Meldern sehr kostengünstig. Die an eine Zentrale angeschlossenen Meldelinien, an welche die verschiedenen Brandmelder angeschlossen sind, sind im Betrieb mit einem Linienstrom beaufschlagt, aus welchem eine Linienspannung resultiert, die im Alarmfall absinkt. Das Endglied dient zur Ermöglichung der Erkennung einer Unterbrechung der Meldelinie.

In Brandmeldeanlagen müssen die Meldelinien ständig auf Störungen hin überwacht und Störungen müssen ohne grosse Verzögerung angezeigt werden, um umgehend behoben werden zu können. Die Verfügbarkeit der Anlage und die Qualität der Sicherung sollen so hoch wie möglich und Standzeiten wegen Reparaturen sollen so kurz wie möglich gehalten werden. Als mögliche Störungen kommen insbesondere Drahtbruch oder Kurzschluss und "schleichender Drahtbruch" oder "schleichender Kurzschluss" infrage.

Bei herkömmlichen Meldelinien der GMT-Technik wird als Endglied ein Widerstand eingesetzt. Um eine Unterbrechung auf der Meldelinie sicher feststellen zu können, muss durch diesen Widerstand ein Strom fliessen, der wesentlich grösser ist als der durch die Brandmelder fliessende Strom, was eine Notstrombatterie einer bestimmten Mindestgrösse bedingt. Zur Reduktion des Stromverbrauchs wurde vorgeschlagen, als Endglied anstatt des Widerstands eine Überspannungs-Schutz-Diode oder TVS-Diode (TVS = transient voltage suppressor) zu verwenden, die sich gegenüber den so genannten "aktiven Endgliedern" dadurch auszeichnet, dass sie robuster, billiger, kleiner und mechanisch einfacher zu handhaben ist. TVS-Dioden ermöglichen zwar eine Erkennung von Drahtbruch und Kurzschluss, haben aber den Nachteil, dass wegen ihres grossen Temperaturgangs aus einer Veränderung der Linienspannung nicht auf einen schleichenden Kurzschluss oder einen schleichenden Drahtbruch geschlossen werden kann.

Einen schleichenden Drahtbruch kann man mit einer kurzzeitigen Erhöhung des Linienstroms detektieren. Dabei geht man davon aus, dass bei einer solchen kurzzeitigen Erhöhung des Linienstroms die Spannung an der TVS-Diode und der Strom in die Brandmelder gleich bleiben. Bei dieser kurzzeitigen Erhöhung des Linienstroms erhöht sich die Linienspannung proportional zum Leitungswiderstand, so dass durch Messung der Linienspannung ein schleichender Drahtbruch erkannt werden kann.

Bei einem schleichenden Kurzschluss sinkt die Linienspannung, was an sich detektiert werden könnte, aber von einem Absinken der Temperatur an der TVS-Diode nicht unterscheidbar und daher nicht praktikabel ist.

Durch die Erfindung soll nun eine Einrichtung der eingangs genannten Art so verbessert werden, dass auch ein schleichender Kurzschluss sicher erkannt wird.

Diese Aufgabe wird erfindungsgemäss dadurch gelöst, dass für die Erkennung von weiteren Störungen zusätzlich eine kurzzeitige Absenkung des Linienstroms erfolgt und dass die zu erkennende weitere Störung ein schleichender Kurzschluss ist.

Durch das kurzzeitige Absenken des Linienstroms kann ein schleichender Kurzschluss erkannt werden. Bei diesem erhält die TVS-Diode zu wenig Strom, um die Nennspannung zu stabilisieren, so dass die Linienspannung überproportional sinkt.

Eine erste bevorzugte Ausführungsform des erfindungsgemässen Verfahrens ist dadurch gekennzeichnet, dass das kurzzeitige Absenken des Linienstroms periodisch erfolgt.

Die Erfindung betrifft weiter eine Einrichtung zur Überwachung einer auf Grenzwertmeldetechnik basierenden Meldelinie einer Brandmeldeanlage, mit an die Meldelinie angeschlossenen Meldern, mit einer Zentrale zur Beaufschlagung der Meldelinie mit einem Linienstrom, mit Mitteln zur Überwachung des Linienstroms und/oder der Linienspannung und mit einem durch eine TVS-Diode gebildeten Endglied der Meldelinie, wobei für die Erkennung von Störungen eine kurzzeitige Erhöhung des Linienstroms erfolgt.

Die erfindungsgemässe Einrichtung ist dadurch gekennzeichnet, dass für die Erkennung von weiteren Störungen zusätzlich eine kurzzeitige Absenkung des Linienstroms erfolgt, und dass die zu erkennende weitere Störung ein schleichender Kurzschluss ist.

Eine erste bevorzugte Ausführungsform der erfindungsgemässen Einrichtung ist dadurch gekennzeichnet, dass die kurzzeitige Absenkung des Linienstroms periodisch erfolgt.

Eine zweite bevorzugte Ausführungsform der erfindungsgemässen Einrichtung ist dadurch gekennzeichnet, dass der Ablauf der Überwachung auf Störungen durch einen Mirokontroller gesteuert ist.

Eine dritte bevorzugte Ausführungsform ist dadurch gekennzeichnet, dass die Messwerte des Linienstroms und der Linienspannung in einem A/D-Wandler gewandelt und anschliessend im Mikrokontroller weiter verarbeitet werden.

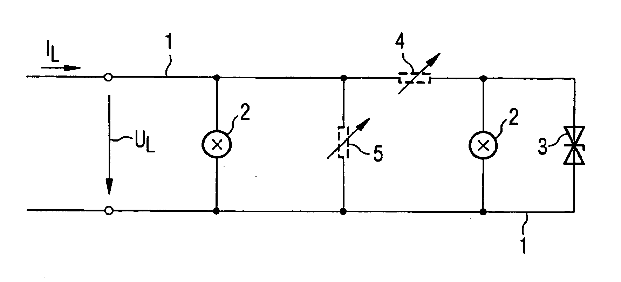

Im Folgenden wird die Erfindung anhand eines in der einzigen Zeichnung dargestellten Ausführungsbeispiels näher erläutert; die Zeichnung zeigt einen Ausschnitt aus einer auf Grenzwertmeldetechnik basierenden Meldelinie einer Brandmeldeanlage mit einem Prinzipschaltbild einer erfindungsgemässen Einrichtung zur Überwachung der Meldelinie auf Störungen.

Die beiden mit dem Bezugszeichen 1 bezeichneten Leitungen symbolisieren eine Meldelinie, die an diese angeschlossenen Brandmelder, von denen nur zwei eingezeichnet sind, sind mit dem Bezugszeichen 2 bezeichnet. Bei den Brandmeldern 2 kann es sich um Rauchmelder, Wärmemelder, Flammenmelder, Brandgasmelder oder Kombinationen von diesen oder um Handfeuermelder handeln. Bei der Meldelinie 1 handelt es sich um eine so genannte Stichleitung, die von einer Zentrale (nicht eingezeichnet) wegführt und mit einem durch eine Überspannungs-Schutz-Diode oder TVS-Diode 3 gebildeten Endglied abgeschlossen ist.

Die dargestellte Meldelinie basiert auf Grenzwertmeldetechnik, auch Gleichstrommeldetechnik oder Kollektivtechnik genannt, bei der die einzelnen Melder nicht adressierbar sind und der oder die einen Alarm auslösenden Melder nicht identifizierbar sind. Selbst-verständlich identifiziert aber die Zentrale die jeweilige Meldelinie. Von der Zentrale wird mit einer Stromquelle (nicht eingezeichnet) ein Gleichstrom I_{L} in die Meldelinie 1 eingespeist. Die Linienspannung U_{L} stellt sich dann ein und hängt im Normalfall von der TVS-Diode 3 und dem Leitungswiderstand ab.

Die TVS-Diode stellt am Ende der Meldelinie 1 eine genau definierte Spannung von beispielsweise 20 V ein. Beim Ansprechen eines Melders 1 zieht dieser mehr Strom, alleine schon nur, um seinen Alarmindikator anzusteuern, und die Linienspannung U_{L} sinkt ab. Erfolgt das Absinken der Linienspannung U_{L} unter einen bestimmten Wert, wird auf Alarm erkannt.

Auf der Meldelinie 1 können im Wesentlichen vier Arten von Störungen auftreten, Drahtbruch, Kurzschluss, schleichender Drahtbruch und schleichender Kurzschluss. Die Erkennung von Drahtbruch und Kurzschluss ist durch Messung der Linienspannung U_{L} einfach und sicher möglich. Dagegen bestehen Probleme bei der Erkennung von schleichendem Drahtbruch und schleichendem Kurzschluss, da TVS-Dioden einen relativ grossen Temperaturgang aufweisen, so dass bei einer Veränderung der Linienspannung U_{L} nicht eindeutig auf einen schleichenden Drahtbruch oder einen schleichenden Kurzschluss geschlossen werden kann.

In der Zeichnung sind zwei Widerstände gestrichelt eingezeichnet, ein Serienwiderstand 4, der den Leitungswiderstand mit einem schleichenden Drahtbruch symbolisiert, und ein Parallelwiderstand 5, der den Leitungswiderstand mit einem schleichenden Kurzschluss symbolisiert.

Einen schleichenden Drahtbruch kann man mit einer kurzzeitigen Erhöhung des Linienstroms I_{L} detektieren. Dabei geht man davon aus, dass bei einer solchen kurzzeitigen Erhöhung des Linienstroms die Spannung an der TVS-Diode 3 und der Strom in die Brandmelder gleich bleiben. Bei dieser kurzzeitigen Erhöhung des Linienstroms I_{L} erhöht sich die Linienspannung U_{L} proportional zum Serienwiderstand 4, so dass durch Messung der Linienspannung U_{L} ein schleichender Drahtbruch erkannt werden kann.

Bei einem schleichenden Kurzschluss erhöht sich durch eine Erhöhung des Linienstroms I_{L} die Spannung am Parallelwiderstand 5, was sich aber wie ein schleichender Drahtbruch darstellt. Für die Störungserkennung wäre dieser Umstand unerheblich, da ja eine Störung erkannt wurde. Für den Monteur, der die Störung beheben muss, ist es aber wichtig zu wissen, um welche Art von Störung es sich handelt.

Eine sichere Erkennung eines schleichenden Kurzschlusses wird aber durch eine kurzzeitige Absenkung des Linienstroms ermöglicht. Denn dadurch erhält die TVS-Diode 3 zu wenig Strom, um die Nennspannung von 20 V zu stabilisieren, so dass die Linienspannung U_{L} überproportional sinkt. Das Absenken des Linienstroms I_{L} wird automatisch periodisch durchgeführt und eine erkannte Störung wird an die Zentrale gemeldet.

Der gesamte Ablauf der Störungsüberwachung wird von einem Mikrokontroller (nicht eingezeichnet) gesteuert. Die Messwerte des Linienstroms I_{L} und der Linienspannung U_{L} werden von einem A/D-Wandler (nicht eingezeichnet) gewandelt und im Mikrokontroller weiter verarbeitet. Zur Unterdrückung von Störungen, wie beispielsweise durch EMV-Einstrahlung, wird bei der Auswertung über mehrere Messwerte gemittelt.

## Patentansprüche

1. Verfahren zur Überwachung einer auf Grenzwertmeldetechnik basierenden Meldelinie (1) einer Brandmeldeanlage auf Störungen, wobei die Meldelinie (1) im Betrieb mit einem Linienstrom (I_{L}) beaufschlagt ist und ein durch eine TVS-Diode (3) gebildetes Endglied aufweist, und eine Überwachung des Linienstroms (I_{L}) und/oder der Linienspannung (U_{L}) sowie für die Erkennung von Störungen eine kurzzeitige Erhöhung des Linienstroms (I_{L}) erfolgt, **dadurch gekennzeichnet, dass** für die Erkennung von weiteren Störungen zusätzlich eine kurzzeitige Absenkung des Linienstroms (I_{L}) erfolgt und dass die zu erkennende weitere Störung ein schleichender Kurzschluss ist.

2. Verfahren nach Anspruch 1, **dadurch gekennzeichnet, dass** das kurzzeitige Absenken des Linienstroms (I_{L}) periodisch erfolgt.

3. Verfahren nach einem der Ansprüche 1 oder 2, **dadurch gekennzeichnet, dass** die Messwerte des Linienstroms (I_{L}) und/oder der Linienspannung (U_{L}) bei der Auswertung über mehrere Messwerte gemittelt werden.

4. Einrichtung zur Überwachung einer auf Grenzwertmeldetechnik basierenden Meldelinie (1) einer Brandmeldeanlage, mit an die Meldelinie (1) angeschlossenen Meldern (2), mit einer Zentrale zur Beaufschlagung der Meldelinie (1) mit einem Linienstrom (I_{L}), mit Mitteln zur Überwachung des Linienstroms (I_{L}) und/oder der Linienspannung (U_{L}) und mit einem durch eine TVS-Diode (3) gebildeten Endglied der Meldelinie (1), wobei für die Erkennung von Störungen eine kurzzeitige Erhöhung des Linienstroms (I_{L}) erfolgt, **dadurch gekennzeichnet, dass** für die Erkennung von weiteren Störungen zusätzlich eine kurzzeitige Absenkung des Linienstroms (I_{L}) erfolgt und dass die zu erkennende weitere Störung ein schleichender Kurzschluss ist.

5. Einrichtung nach Anspruch 4, **dadurch gekennzeichnet, dass** die kurzzeitige Absenkung des Linienstroms (I_{L}) periodisch erfolgt.

6. Einrichtung nach Anspruch 5, **dadurch gekennzeichnet, dass** der Ablauf der Überwachung auf Störungen durch einen Mirokontroller gesteuert ist.

7. Einrichtung nach Anspruch 6, **dadurch gekennzeichnet, dass** die Messwerte des Linienstroms (I_{L}) und der Linienspannung (U_{L}) in einem A/D-Wandler gewandelt und anschliessend im Mikrokontroller weiter verarbeitet werden.

8. Einrichtung nach Anspruch 6 oder 7, **dadurch gekennzeichnet, dass** bei der Auswertung der Messwerte des Linienstroms (I_{L}) und der Linienspannung (U_{L}) eine Mittelung über mehrere Messwerte erfolgt.

## Claims

1. Method for monitoring a limit-indicator-technology-based detector line (1) of a fire detection system for faults, wherein the detector line (1) has a line current (I_{L}) applied to it during operation and has a final element formed by a TVS diode (3), the line current (I_{L}) and/or the line voltage (U_{L}) are monitored, and the line current (I_{L}) is increased briefly for the purpose of detecting faults, **characterised in that** in addition the line current (I_{L}) is reduced briefly for the purpose of detecting further faults, and that the further fault requiring to be detected is a creeping short-circuit.

2. Method according to claim 1, **characterised in that** the brief reduction in the line current (I_{L}) is repeated periodically.

3. Method according to claim 1 or 2, **characterised in that** the measured values of the line current (I_{L}) and/or the line voltage (U_{L}) are averaged over a plurality of measured values during the evaluation.

4. Device for monitoring a limit-indicator-technology-based detector line (1) of a fire detection system, said device having detectors (2) connected to the detector line (1), having a control centre for applying a line current (I_{L}) to the detector line (1), having means for monitoring the line current (I_{L}) and/or the line voltage (U_{L}), and having a final element of the detector line (1), said final element being formed by a TVS diode (3), wherein the line current (I_{L}) is increased briefly for the purpose of detecting faults, **characterised in that** in addition the line current (I_{L}) is reduced briefly for the purpose of detecting further faults and that the further fault requiring to be detected is a creeping short-circuit.

5. Device according to claim 4, **characterised in that** the brief reduction in the line current (I_{L}) is repeated periodically.

6. Device according to claim 5, **characterised in that** the process of monitoring for faults is controlled by means of a microcontroller.

7. Device according to claim 6, **characterised in that** the measured values of the line current (I_{L}) and the line voltage (U_{L}) are converted in an A/D converter and subsequently processed further in the microcontroller.

8. Device according to claim 6 or 7, **characterised in that** during the evaluation of the measured values of the line current (I_{L}) and the line voltage (U_{L}) an average is taken over a plurality of measured values.

## Revendications

1. Procédé de contrôle de pannes sur une ligne ( 1 ) d'avertissement reposant sur une technique d'avertissement de valeur limite d'une installation d'avertissement d'incendie, dans lequel la ligne ( 1 ) d'avertissement est alimentée en fonctionnement en un courant ( I_{L} ) de ligne et a un élément d'extrémité formé par une diode ( 3 ) TVS, et on effectue un contrôle du courant ( I_{L} ) de ligne et/ou de la tension ( U_{L} ) de ligne ainsi que, pour la détection de pannes, une augmentation de courte durée du courant ( I_{L} ) de ligne, **caractérisé en ce que**, pour la détection d'autres pannes, on effectue supplémentairement un abaissement de courte durée du courant ( I_{L} ) de ligne et **en ce que** l'autre panne à détecter est un court-circuit de fuite.

2. Procédé suivant la revendication 1, **caractérisé en ce que** l'abaissement de courte durée du courant ( I_{L} ) de ligne s'effectue périodiquement.

3. Procédé suivant l'une des revendications 1 ou 2, **caractérisé en ce que** l'on fait la moyenne sur plusieurs valeurs de mesure des valeurs de mesure du courant ( I_{L} ) de ligne et/ou de la tension ( U_{L} ) de ligne lors de l'exploitation.

4. Dispositif de contrôle d'une ligne ( 1 ) d'avertissement reposant sur une technique d'avertissement d'une installation d'avertissement d'incendie, comprenant des avertisseurs ( 2 ) raccordés à la ligne ( 1 ) d'avertissement, une centrale d'alimentation de la ligne ( 1 ) d'avertissement en un courant ( I_{L} ) de ligne, des moyens de contrôle du courant ( I_{L} ) de ligne et/ou de la tension ( U_{L} ) de ligne et un élément d'extrémité formé par une diode ( 3 ) TVS de la ligne ( 1 ) d'avertissement, dans lequel, pour la détection de pannes, il est effectué une augmentation de courte durée du courant ( I_{L} ) de ligne, **caractérisé en ce que**, pour la détection d'autres pannes, il est effectué supplémentairement un abaissement de courte durée du courant ( I_{L} ) de ligne et **en ce que** l'autre panne à détecter est un court-circuit de fuite.

5. Dispositif suivant la revendication 4, **caractérisé en ce que** l'abaissement de courte durée du courant ( I_{L} ) de ligne s'effectue périodiquement.

6. Dispositif suivant la revendication 5, **caractérisé en ce que** le déroulement du contrôle des pannes est commandé par un microcontrôleur.

7. Dispositif suivant la revendication 6, **caractérisé en ce que** les valeurs de mesure du courant ( I_{L} ) de ligne et de la tension ( U_{L} ) de ligne sont transformées dans un convertisseur A/N et sont traitées ensuite davantage dans le microcontrôleur.

8. Dispositif suivant la revendication 6 ou 7, **caractérisé en ce que**, lors de l'exploitation des valeurs de mesure du courant ( I_{L} ) de ligne et de la tension ( U_{L} ) de ligne, on effectue une moyenne sur plusieurs valeurs de mesure.
